# EUROPEAN PATENT APPLICATION

(11) **EP 2 197 026 A1**
(43) Date of publication of application: **16.06.2010**
(21) Application number: 08171573.2
(22) Date of filing: 12.12.2008
(51) Int. Cl.: H01L 21/67, H01L 21/00

(54) **Integration of a processing bench in an inline coating system**

(71) Applicant: Applied Materials, Inc., Santa Clara, CA 95054 (US)
(72) Inventor: Haberkorn, Edgar, 63637 Jossgrund (DE); Maurer, Philipp, 63820 Elsenfeld (DE)
(74) Representative: Zimmermann & Partner

(57) **Abstract**

An insert apparatus for a substrate coating system, the insert apparatus including: an insert element 100 for being operated within a coating system, the insert element including a processing bench, said processing bench being adapted for receiving a coating tool for applying a coating to a substrate, a carrier 110 for carrying the insert element 100, a first positioner 130 collaborating with the carrier 110 for inserting said insert element 100 into a processing chamber 150 of the coating system and/or retracting said insert element 100 from said processing chamber 150, and a second positioner 140 for fine positioning of said insert element 100 within said processing chamber 150.

## Description

### FIELD

The present disclosure generally relates to substrate coating technology solutions involving equipment, processes and materials used in the deposition, patterning, and treatment of substrates and coatings, with representative examples including (but not limited to) applications involving: semiconductor and dielectric materials and devices, silicon-based wafers, flat panel displays (such as TFTs), masks and filters, energy conversion and storage (such as, fuel cells, and batteries, photovoltaic cells, in particular thin-film solar cells), solid-state lighting (such as LEDs and OLEDs), magnetic and optical storage, micro-electro-mechanical systems (MEMS) and nano-electro-mechanical systems (NEMS), micro-optic and opto-electro-mechanical systems (NEMS), micro-optic and optoelectronic devices, transparent substrates, architectural and automotive glasses, metallization systems for metal and polymer foils and packaging, and micro- and nano-molding. More specifically, the present disclosure relates to insert apparatuses for a substrate coating system comprising an insert element with a processing bench. Further, the present disclosure also relates to methods for inserting an insert element into a processing chamber.

### BACKGROUND

Usually, in processing chambers forming part of coating systems, the equipment which may be necessary to carry out the different processing steps are mounted on flanges, covers or directly to the walls in the interior of the processing chamber. In order to perform the servicing of those parts, the chamber is typically provided with a detachable cover which usually rests at the top, typically, on a chamber opening. However, due to the placement and size of the components, servicing in this kind of systems is an inconvenient and arduous task. Consequently, long periods of downtime are unavoidable in this type of coating system when maintenance is required. In addition, other problems may arise regarding the sealing of chamber openings after servicing is performed.

### SUMMARY

In view of the above, insert apparatuses for a substrate coating system is provided. Further, methods for inserting an insert element in a substrate coating system are also provided.

According to aspects of the present disclosure, the insert apparatus includes: an insert element for being operated within a coating system, the insert element including a processing bench, the processing bench being adapted for receiving a coating tool for applying a coating to a substrate; a carrier for carrying the insert element; a first positioner collaborating with the carrier for inserting the insert element into a processing chamber of the coating system and/or retracting the insert element from the processing chamber; and a second positioner for fine positioning of the insert element within the processing chamber.

According to another aspect of the present disclosure, it is provided an insert apparatus for a substrate coating system, the insert apparatus including: an insert element for being operated within a coating system, the insert element including a processing bench, the processing bench being adapted for receiving a coating tool for applying a coating to a substrate, a carrier for carrying the insert element, and an electrical unit block for providing an operating voltage to the processing bench, the electrical unit block being movable along with the carrier.

According to an additional aspect of the present disclosure, an insert apparatus for a substrate coating system is provided, the insert apparatus including: an insert element for being operated within a coating system, the insert element including a processing bench, the processing bench being adapted for receiving a coating tool, a carrier coupled to the insert element, a first positioner collaborating with the carrier for performing at least insertion of the insert element into a processing chamber or retraction of the insert element from the processing chamber, and a second positioner adapted for being coupled to the insert element, the second positioner being placed within said processing chamber.

According to a further aspect of the present disclosure, a method for inserting an insert element in a substrate coating system is provided, the method including: disposing the insert element on a carrier, disposing an electrical unit block in the substrate coating system so that the electrical unit block is movable along with the carrier, and positioning the insert element into a processing chamber of the coating system by displacing the carrier whereby the electrical unit block is also displaced.

According to yet another aspect of the present disclosure, a method for inserting an insert element in a substrate coating system is provided, the method including: disposing the insert element on a carrier, grossly positioning the insert element into a processing chamber of the coating system; and finely positioning of the insert element within the processing chamber.

Embodiments are also directed to apparatuses for carrying out the disclosed methods and including apparatus parts for performing each described method step. These method steps may be performed by way of hardware components, a computer programmed by appropriate software, by any combination of the two, or in any other manner. Furthermore, embodiments are also directed to methods by which the described apparatus operates or by which the described apparatus is manufactured. It includes method steps for carrying out functions of the apparatus or manufacturing parts of the apparatus.

Further aspects, details and advantages are evident from the dependent claims, the description and the accompanying drawings.

### BRIEF DESCRIPTION OF THE DRAWINGS

Some of the above-indicated and other, more detailed aspects of the present disclosure will be described in the following description and partially illustrated with reference to the figures. Therein:
- Figures 1a and 1b: show embodiments of the insert apparatus as described herein in a schematic lateral cross-sectional view, in each figure the insert element being in a different position with respect to the coating system.
- Figures 2-4,: show embodiments of the insert apparatus according to the present disclosure in a schematic lateral cross-sectional view.
- Figures 5a to 5e: show an embodiment of the insert apparatus according to the present disclosure, the figures representing an operational sequence of the insert apparatus.
- Figure 6: shows another embodiment of the insert apparatus according to the present disclosure in a schematic lateral cross-sectional view.
- Figure 7: shows a processing facility including multiple insert apparatuses according to the embodiments of the present disclosure.
- Figure 8: shows, in an exploded view, a typical insert element including a processing bench for metal evaporation on a substrate.

### DETAILED DESCRIPTION OF THE DRAWINGS

Reference will now be made in detail to the various embodiments, one or more examples of which are illustrated in the figures. Each example is provided by way of explanation and is not meant as a limitation of the present disclosure. For example, features illustrated or described as part of one embodiment may be used on or in conjunction with other embodiments to yield yet a further embodiment. It is intended that the present disclosure includes such modifications and variations.

Within the following description of the drawings, the same reference numbers refer to the same components. Generally, only the differences with respect to the individual embodiments are described.

The embodiments of the present disclosure provide an insert apparatus for a system for coating a substrate, the insert apparatus having an insert element. Disposed on the insert element there is a processing bench. The processing bench includes a coating tool which is used for applying a coating to a substrate. Typically, the coating tool may be for evaporation, in particular for metal evaporation, such as Aluminum evaporation. Further, the insert apparatus includes a carrier for carrying the insert element. Typically, the carrier may be used for inserting the insert element into a processing chamber, retracting the insert element therefrom, or for performing both operations (i.e. insertion and retraction). Typically, the insert element is mounted on the carrier. In some embodiments, the insert element is movably mounted on the carrier. According to embodiments of the present disclosure, the insert apparatus includes first and second positioners. The first positioner may be used for gross positioning of the insert element within the processing chamber. In particular, the first positioner collaborates with the carrier, e.g. by gross positioning the carrier with respect to the chamber, for inserting the insert element within the chamber. In some embodiments, the second positioner is for fine positioning of the insert element within the coating system. Further, the insert apparatus according to the present disclosure may include a link element for coupling the insert element to the carrier.

Different processing tools might be arranged on an insert element which can thereby be easily inserted in the processing chamber or extracted therefrom. Thereby, servicing of the tools in the processing chamber and operation of the coating system is simplified. In addition, coating systems using insert elements are highly flexible since, thereby, modularity of the system is enhanced.

Precision in the positioning of the insert element within the processing chamber might be an issue in coating systems based on the use of insert elements. Precise positioning of the insert element within the chamber might be of importance for achieving uniform coating of the substrate, i.e. uniform thickness and quality of the layers coated on the substrate.

Exact positioning of the insert element may be complicated due to different issues, such as the mass of the coating tools mounted on the insert elements. In particular, for some processing steps, such as metal coating of a substrate, the weight of the items to be placed on the insert element, such as evaporators or voltage generators, are high and makes the correct placement of the insert element within the chamber especially difficult.

In particular, the implementation of metal evaporators such as Aluminum evaporators in an insert element might be difficult. This is due to the typically high mass of the evaporation tools. Further, the integration in the coating system of the high current transformers which are typically needed for metal evaporation is difficult. Presently, Aluminum coating in an insert element based coating system might be implemented using screen-printing techniques since the tools required for this method are relatively light. However, in comparison with Aluminum evaporation, screen printing techniques bring lower throughput, cause higher costs through the Aluminum paste to be used, and need a higher number of processing steps since multiple heating stages are necessary.

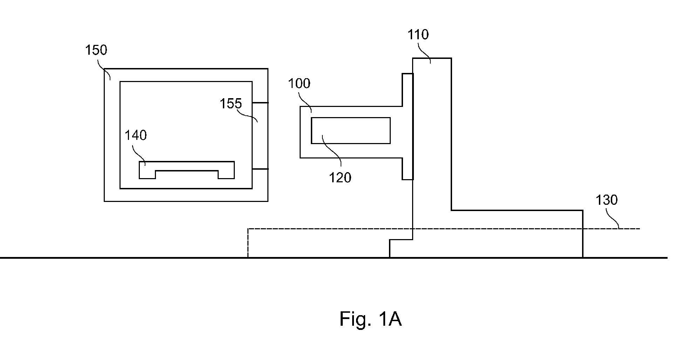

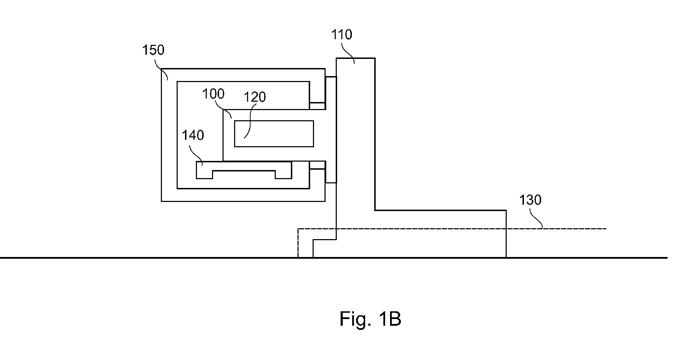

Fig. 1a shows an embodiment of the insert apparatus in an open position. Fig. 1b shows an embodiment of the insert apparatus in a closed position. Both figures show the insert apparatus in a schematic lateral cross-sectional view. In the open position, the insert element is placed outside the processing chamber. In the closed position, the insert element is placed so that the processing chamber is closed and the processing chamber is ready for operation.

As depicted in Fig. 1a, the insert element 100 includes a processing bench 120. Further, the insert element 100 is typically attached to the carrier 110. Typically, the carrier is displaced through the first positioner 130. Disposed within the processing chamber 150 there is a second positioner 140. Typically, the processing chamber 150 forms part of a coating system. Typically, the insert element 100 is introduced in the processing chamber 150 through the opening 155. Typically, the insert element 100 is constructed so that when it is placed in the operational position, the opening 155 is closed by the insert element 100 itself. In particular, the insert element 100 may be designed so that the processing chamber 150 is sealed when the insert apparatus is in the closed position.

In typical embodiments of the present disclosure, the closed position of the insert apparatus is achieved by: i) gross positioning the insert element into the processing chamber, and ii) fine positioning of said insert element within the processing chamber. Typically, at the end of the fine positioning step, the processing chamber is closed. In particular, e.g. for vacuum operation of the coating system, the processing chamber may be closed in a sealable manner.

Typically, in order to introduce the insert element 100 into the processing chamber 150 or retract it therefrom, the carrier 110 is displaced, generally by sliding, through the first positioner 130. Therefore, the carrier 110, along with the insert element 100, may be gross positioned with respect to the processing chamber 150. In some embodiments, the first positioner 130 includes a track, such as rails, railways or the like, which may be placed outside the processing chamber 150 and on which the carrier 110 may be displaced in order to position the insert element 100 with respect to the processing chamber 150.

Once the insert element 100 is placed within the processing chamber 150, the insert element 100 may be more precisely placed within the processing chamber 150 through the second positioner 140. Further, the second positioner 140 may include guiding elements, such as rails, railways or the like, which are typically placed within the processing chamber 150. In this case, the insert element 100 may be displaced thereon in order to be finely positioned within the processing chamber 150.

Thereby, through the first positioner and the second positioner, the insert element along with the processing bench can be placed in a position so that the substrate coating system can be operated conveniently.

By the combination of a gross positioner for insertion of the insert element and a fine positioner for the positioning of the insert element within a coating system, the processing bench may be positioned with a great exactitude within the processing chamber. Thereby, coating may be achieved with high uniformity over the whole surface of the substrate. This combination is efficient even in the case that heavy loads are disposed on the insert element. Particularly, this may be the case when the processing bench is designed for metal evaporation, such as Aluminum evaporation. Furthermore, a high reproducibility in the coating of substrates may be realized, even after servicing of the insert element and the elements thereon, or even after exchanging of the insert element using the insert apparatus according to the embodiments of the present disclosure.

In some embodiments, the first positioner 130 is composed of guiding elements, such as rails, railways, conveyors or the like. Typically, these guiding elements are arranged externally to the processing chamber 150. In particular, the rails or the like may be fixed to the floor of the facility where the coating system is placed. Generally, the rails are designed to support and displace heavy loads. A typical heavy load supported by the rails is at least 2 ton or 2.5 ton. Typically, the rails may support a maximal load of 3.5 ton or a maximal load of 4 ton. However, the rails may be designed to support even higher loads. For processing chambers where the load to be displaced and supported by the first positioner is lighter, such as a load weight between 0.5 ton and 2.5 ton, the rails might be appropriately designed in order to reduce costs and space of the facility. For the gross positioning of the insert element 100 in the processing chamber 150, the carrier 110 may slide on the rails or the like. Thereby, the insert element 100 is grossly, i.e. coarsely, positioned within the processing chamber 150. Further, it is typical that displacing elements, such as rollers or sliding devices, are placed on the carrier 110 and coupled to the first positioner 130 in order to facilitate gross positioning of the insert element 100. A typical tolerance for the gross positioning of the insert element 100 through the first positioner 130 is at least ±3.5 mm or ±7.5 mm. Higher tolerances values are also affordable for correct functioning of the coating system.

The mechanical force necessary for the gross positioning of the carrier 110 may typically be generated by a drive system. The driving force may be generated by any kind of motor or the like. The drive system may be placed in the carrier 110 itself, external thereto, or form part of the first positioner 130. Alternatively, drive systems may also have different parts placed at different elements of the insert apparatus. In some embodiments, coupling of the mechanical force from the drive system to the carrier 110 may be achieved through a cable carrier, drag chains, energy chains, cable chains or the like.

In some embodiments, the second positioner 140 is composed of rails, railways or the like. Typically, the rails or the like may be fixed to a part of the processing chamber 150. For the positioning of the insert element 100, the insert element 100 may slide on the rails or the like. Further, it is typical that the insert element 110 includes displacing elements, such as rollers or sliding devices. Those elements are typically coupled to the second positioner 140 in order to facilitate fine positioning of the insert element 100 within the processing chamber 150. A typical tolerance for the fine positioning of the insert element 100 through the second positioner 140 is at least ±0.7 mm or ±1.2 mm. The typical tolerance for the fine positioning can be maximally ±2.7 mm or ±3.4 mm.

Typically, the second positioner may include devices, such as clamps or the like, to fix the insert element in the closed position. Thereby, the position of the insert element and of the processing bench within the processing chamber may be fixed to facilitate operation of the system.

Typically, the second positioner 140 is placed on a bottom surface of the processing chamber 150. Alternatively, the second positioner 140 may be placed in a pedestal-like platform placed in a bottom area of the processing chamber 150. In another typical implementation of the system, the second positioner 140 is arranged in the lateral areas of the processing chamber 150.

For retraction of the insert element 100 from the processing chamber 150 it is typical: i) to displace the insert element 100 along with the processing bench 120 from the position at which the processing chamber 150 is operated, and ii) to extract the insert element 100 along with the processing bench 120 from the processing chamber 150, typically by displacement of the carrier 110. Both operations may be realized in collaboration with the first and second positioner. Optionally, retraction of the insert element 100 may be performed by collaboration of the first positioner 130 with the carrier 110, in particular without utilization of the second positioner 140.

In order to accomplish different tasks, the insert element may be displaced with respect to the carrier. Some of these tasks are, for example: i) positioning of the insert element so that it may be inserted or extracted through the opening of the processing chamber; ii) coupling of the insert element with the second positioner; or iii) displacement of the insert element for facilitating servicing or exchanging of the insert element.

Typically, the insert element is disposed on the carrier in the form of a cantilever structure. Thereby, the insert element typically has the form of a projecting beam or member supported at an end by a flange, the flange being attached to the carrier. Typically, the flange is designed to function as a means of closure of the processing chamber when the insert element is inserted in the processing chamber in the operational position. By disposing the insert element as a cantilever structure, a free space is left under the insert element which facilitates servicing of the components mounted thereon.

Alternatively, the insert apparatus may include more than one insert element. In that case, it is typical to dispose the inserts aligned horizontally with each other. However, other configurations are also possible such as, e.g., a vertical disposition of the insert elements where one insert element is disposed above the other. Those insert elements may be supported by a flange, the flange being attached to the carrier. The plurality of insert elements may be arranged on the flange forming an array-like structure. The different insert elements may comprise processing benches designed for fulfilling different processes on the substrate within the same processing chamber.

Further, in some embodiments of the present disclosure, the insert element is coupled in a detachable manner to the carrier. Thereby, the insert element may readily be exchanged and thus reducing the downtime of the system during servicing of components disposed on the insert element.

In some embodiments, the insert element is movably coupled to the carrier through a link element. Typically, the link element includes a hoist device having drives and actuator devices to displace the insert element with respect to the carrier in any spatial direction.

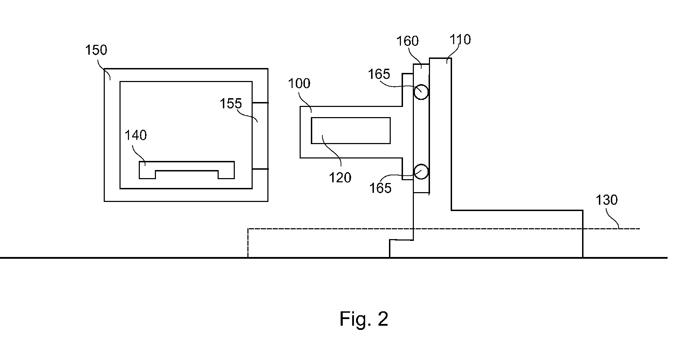

The embodiment shown in Fig. 2 is similar to the embodiment shown in Figs. 1a and 1b. The embodiment shown in Fig. 2 further includes exemplarily a link element 160 for movably coupling the insert element 100 to the carrier 110. Typically, the link element 160 is adapted to allow the displacement of the insert element 100 with respect to the carrier 110 in any spatial direction.

The hoist device 165 may be placed in the link element 160, in the carrier 110, or in the insert element. Typically, the hoist device 165 is composed of a drive system and couplings for actuation of the insert element 100. Typically, the drive system in the hoist device 165 is based on an air cylinder system. Other similar devices may also be used in the drive system. In some particular implementations of the inserting apparatus, the hoist device 165 is designed for displacement of the insert element in only one spatial direction, in particular the vertical or horizontal direction.

Through the link element, the insert element may be conveniently positioned in order to accomplish different tasks such as for example: i) positioning of the insert element so that it can be inserted or extracted through the opening of the processing chamber; ii) coupling of the insert element with the second positioner; and iii) displacement of the insert element for facilitating servicing or exchanging of the insert element.

Therefore, through the link element, the insert element may be positioned independently from the carrier, increasing the flexibility of the system and the exactitude of positioning of the insert element within the coating system.

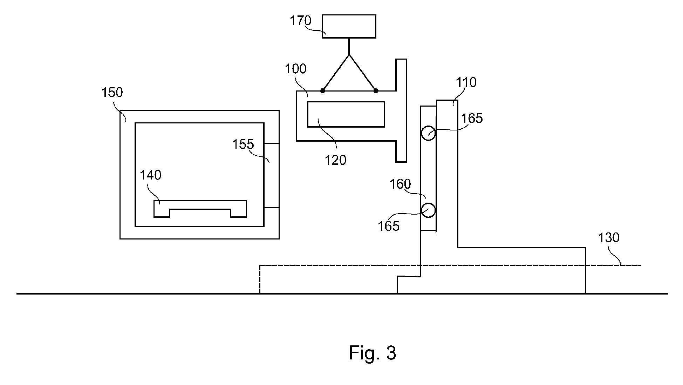

Fig. 3 shows an insert element 100 which has been detached from the carrier by a detaching device 170. Typically, the detaching device 170 consists of a crane arm or the like which can be coupled to the insert element 100. Fig. 3 shows a typical configuration where the insert element 100 is detached from the link element 160. Through the detaching device 170, the insert element 100 may be easily replaced in the system for the cases where servicing, repair or implementation of a different process in the processing chamber is required. Typically, the detaching device 170 is designed to accurately place the insert element 100 in the link element 160. A typical weight of the load to be carried by the detaching device 170 is at least 0.5 ton or 1 ton. Typical load weight may be approximately 1.5 ton.

Other configurations are also possible where, e.g. the insert element is linked directly to the carrier and can be detached therefrom. Another possible configuration is where the insert element is coupled to the carrier through a link element, and the connection between the link element and the carrier is detachable. In this latter configuration, the insert element, together with the link element, is detached from the carrier.

It is typical that, for detachably coupling of the insert element, guides and locking mechanisms may be provided in the link element. In other typical configurations, those devices for detachably coupling may be provided in the carrier, in the insert elements or have multiple elements provided in different parts of the system.

By detachably coupling the insert element to the carrier, an insert element which is not longer operational can be exchanged by a ready-to-work insert element. An insert element exchanged in this manner may be serviced while the individual chamber is placed back into operation. Further, if the operation of the coating system must be varied, i.e. a different process within individual processing chambers or parts of the system is to be performed then a particular processing step may be modified simply by exchanging the insert element through the detaching device.

In some embodiments, the insert apparatus further includes an electrical unit block for providing an operating voltage and current to the processing bench, the electrical unit block being movable along with the carrier. In the particular case that the processing bench includes tools for evaporation of metals, the electrical unit typically consists of a transformer for providing a high current to the processing bench. The electrical unit may be placed on the carrier. As an example, a typical transformer for metal evaporation weights at least 80 kg or at least 130 kg. As a particular example, such a transformer with a maximal power flow of approximately 14 kVA may weight about 110 kg. Other transformers with different maximal power are also typically used depending on the process to be carried out in the processing chamber.

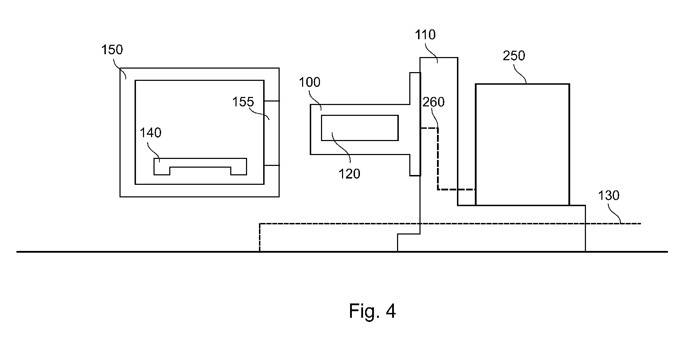

Fig. 4 shows a typical configuration of the inserting apparatus, where an electrical unit 250 is disposed on the carrier 110. Thereby, the electrical unit 250 is displaced along with the carrier 110. Typically, the electrical unit 250 is electrically connected to the processing bench 120 through the electrical connection 260. The electrical connection 260 may provide the supply voltage or current for operation of the processing bench 120. The electrical connection 260 may also be used for providing any other supply voltage or current necessary for operation of the coating system.

Typically, the electrical connection 260 can be attached to different elements of the inserting apparatus, in particular to the carrier 110, the insert element 100, or both of them. It is also typical that the electrical connection 260 consists of flexible cables, in particular flexible copper bands. Thereby, the elements of the insert apparatus which are attached to the electrical connection 260, in particular the carrier 110, the insert element 100 and the processing bench 120, are mechanically decoupled from each other. Thereby, it is avoided that vibrations are transmitted to the insert element 100 through the electrical connection 260.

Typically, the electrical unit consists of a transformer for providing voltage and current in order to operate the processing bench or any other component included in the insert element. Typically, the voltage and current generated by the electrical unit depends on the power requirements of the components in the insert element to which the electrical energy is provided. Further, the electrical unit may be designed so that a variable voltage and current may be supplied. Thereby, the electrical unit can be compatible with different electrical-supply requirements. More particularly, thereby, the electrical unit may be compatible with different insert elements designed to accomplish different processing steps.

Disposing of the electrical unit so that it is movable along with the carrier is particularly advantageous when the operating input for the processing bench is a high-current, since highly massive transformers are then needed. Such massive transformers are typically difficult to place inside the processing chamber. Therefore, in prior systems, such massive transformers are commonly fixed outside the chamber. This may cause problems related to the cabling, such as use of long cables, especially when the elements connected to the electrical unit are extracted from the processing chamber through the insert apparatus. This is in particular relevant when the electrical unit generates high current, e.g. for metal evaporation. In this case, high currents may cause space problems since for this case it is typical to use bulky cabling. Further, cables for high current placed within the processing chamber may cause interferences to other system components placed within the processing chamber.

Moving the electrical unit along with the carrier is advantageous for the operation of the insert apparatus described in the present disclosure. Firstly, operation of the coating system is simplified since, e.g., wiring is reduced and it makes unnecessary to disconnect the components in the insert element from the electrical unit when servicing is required. Moreover, these cables may be advantageously implemented since they can be placed almost entirely outside of the processing chamber. In particular, the use of long cables for the electrical connection is avoided since the distance between the electrical unit and the processor bench remains basically unchanged. Thereby, operation of the insert apparatus is safer since those cables usually carry high current. Further, the exact positioning of the insert element is facilitated since the typically high weight of the electrical unit is displaced by the first positioner, which is adapted for carrying high weights, and does not interfere in the fine positioning of the insert element.

Further, it may be particularly advantageous to combine in an insert apparatus: a) an electrical unit which is disposed so that it is movable along with the carrier, and b) first and second positioners. Thereby, the electrical unit can be displaced along with the carrier through the first positioner. Further, thereby, the insert element may be finely positioned independently of the electrical unit. In this manner, the electrical unit, even in the case it is highly massive, does not interfere in the exact placement of the insert element within the processing chamber. Further, thereby, the electrical connection between the electrical unit and the insert element might be advantageously implemented so that cabling does not interfere in the fine positioning of the insert element within the processing chamber.

For some applications, in particular for applications where the processing bench is for metal evaporation, such as Aluminum evaporation, the electrical connection may be designed for conducting high-current. A typical current conducted through the electrical connection is of maximally 800 A, more typically maximally 1000 A or even 1170 A. A typical electromotive force generated by the electrical unit in order to generate the current is of about 12 V. However, other voltages may be applied to generate the current.

For some particular applications, the electrical connection may not be directly attached to elements of the inserting apparatus, but connected to the processing bench through a multi-contact connector. In this case, the electrical connection between the electrical unit and the components in the insert element may be realized by vertical displacement of the insert element.

In the case that the processing bench contains coating tools for evaporation of metals, in particular for evaporation of Aluminum, the current for metal evaporation is typically high, in particular at least 600 A or 650 A. The typical current for metal evaporation can be maximally 950 A or 1000 A. Due to these high-current values, the electrical unit for this kind of applications may be particularly massive. The minimum weight of the electrical unit for that particular case of Aluminum evaporation is typically 0.8 ton, such as 1.1 ton.

Typically, the insert element and the coating system are designed so that a planar substrate is conveyed in an essentially horizontal fashion through processing chambers. All the same, the present disclosure is intended to envisage vertical guidance of the substrate, as well.

By the inserting apparatus described in the embodiments of the present disclosure, the relative position between the substrate and the coating tools may be reproduced with a great exactitude when an insert element is placed at the operational position for processing of the substrate. High positioning precision of the insert element is particularly important for systems where coating is realized pseudo-statically. By pseudo-static coating, the substrate to be coated is conveyed to a coating position where it remains stationary during the coating process. Further, high positioning precision of the insert element ensures high reproducibility in the processing of multiple substrates even after servicing of tools disposed on the insert element by extraction and insertion of the insert element.

It is typical that the insert element includes substrate transport devices for conveying of the substrate. The substrate transport devices may be rollers or any other kind of conveyor device which cause the substrate to move. These substrate transport devices may form part of the insert element. Alternatively, the substrate transport device may be attached to the insert element before the insert element is inserted into the processing chamber or once the insert element is in the processing chamber. Typical substrates include bands, slices or wafers of materials such as metals, insulators, or semiconductors.

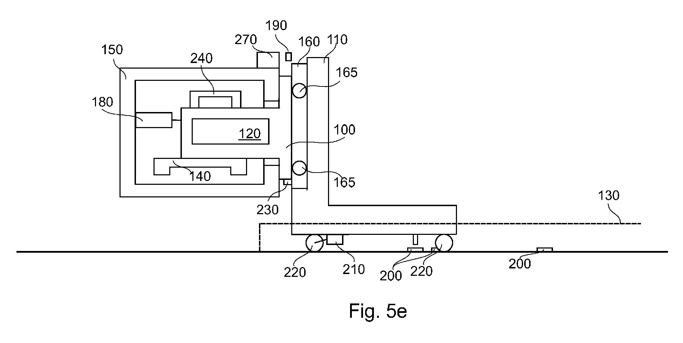

The insert element may include a drive system which generates torsional moment for actuation of the substrate transport device. Typically, the torsional moment is transmitted through belts or similar devices for conveying of the substrate. Typically, the substrate transport device includes transport rollers, whereto the transmitted torsional moment is coupled. Typically, the torsional moment generated by the drive system is coupled to the substrate transport device through magnetic coupling. Magnetic coupling allows letting free room between the material to be coated and the substrate. Thereby, it is facilitated that no components of the coating system are coated during processing of the substrate (see below, Fig. 5e). Further, contact-free couplings, such as magnetic coupling, avoid wearing of the actuation elements to be coupled.

It is typical that the substrate is loaded on a conveyor which collaborates with the substrate transport device. Typically, the conveyor may lie on stub transport rollers. Typically, only outer boundaries of the conveyor are in contact with the stub transport rollers. Thereby, a free space is left under the substrate which may be used to bring the material to be coated on the substrate by evaporation, sputtering or any other coating method known in the art. In the interior of the processing chamber there may be placed, in particular, one or more couplings for the purpose of coupling transport devices, which may be attached to the insert element, with the substrate. The components of the substrate transport device and the drive system may be conveniently protected by shields to prevent the pick-up of coating material.

The use of insert elements reduces the number of devices which must be placed in a fixed fashion inside a processing chamber. Typically, all the elements which essentially remain inside the chamber are process-monitoring sensors and the transport-roller couplings. Thus, in principle, the processing chamber is merely equipped with those components which do not need to be accessed regularly. Typically, the processing chamber and the insert element are designed so that processing of the substrate can be carried out under vacuum conditions.

In typical embodiments, the coating tools are intended to be for evaporation of a coating material, in particular for evaporation of metals such as Aluminum. However, embodiments according to the present disclosure are also intended to include tools in conjunction with other coating techniques, such as, e.g., sputtering of a coating, or the use of an ion source for the preliminary or subsequent treatment of the substrate. Generally, the coating tools are available for maintenance purposes as soon as the insert element has been pulled out of the processing chamber.

Typically, further coating-system components are integrated within the insert element, more particularly in the processing bench. These coating-system components can usually undergo process-induced wear, dirt pick-up or are exposed to coating material. In the embodiments according to the present disclosure, all these components are easily accessible.

Typically, the insert element includes a device, such as a cooling plate or the like, for cooling the shields, screens and/or the components for coating. Further, the insert element may be supplied with a cooling medium which is guided, via lines, to the corresponding components that are cooled.

In addition, an insert element forming part of typical embodiments may optionally include: connections for the supply of media, supply or disposal connections for supplying gas, supply or disposal connections for cooling water to shields or cathodes, or supply or disposal connections for voltage. Those connections and lines may be provided at an insert element portion which may be located outside the processing chamber of the coating system.

An insert element forming part of an insert apparatus as described by typical embodiments will, typically, include shields, screens, or the combination of both. The insert element may be structured in such a way that screens are attached at suitable points in order to prevent the interior of the processing chamber or other components from being affected by dirt pick-up. In this way, no coating material will reach the space outside the insert element.

Typically, the processing bench where the coating tools are incorporated is constructed to form an evaporator drawer mounted on the insert element. Typically, the evaporator drawer includes a wire feeder for feeding a coating material to be evaporated within the coating system. Generally, the coating material is heated in an evaporator boat arranged in the drawer so that effective evaporation of the material is produced. Typically, heating is accomplished by coupling an electrical current to an electrically conductive material forming part of the evaporator boat. It is also typical that a shutter is arranged on the processing bench to control the exposure of the substrate to the coating material being evaporated. Further, the evaporator drawer may include a device for cooling shields, screens and/or other components for coating. The evaporator drawer may be supplied with a cooling medium which is typically guided, via lines, to the corresponding components that are to be cooled.

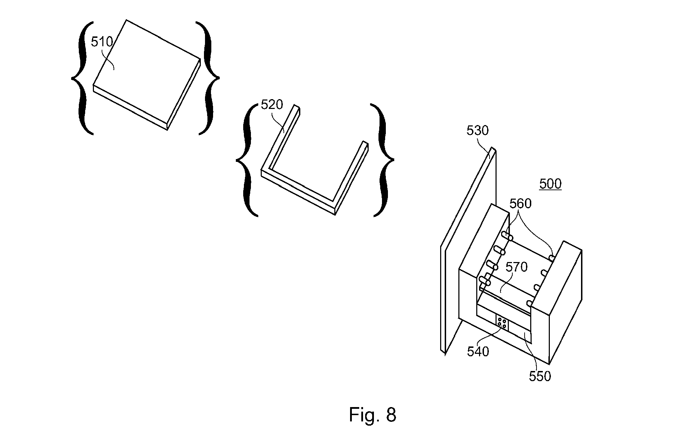

Fig. 8 shows, in an exploded view, a typical implementation of an insert element 500 compatible with the embodiments described herein. Although according to other embodiments not all of the elements depicted in Fig. 8 are necessary, it shall be exemplarily explained in view of Fig. 8. In particular, the insert element 500 depicted in Fig. 8 is a typical design for evaporation of materials. More particularly, the insert element 500 is a typical design where the coating tools are mounted to form an evaporator drawer. The insert element 500 includes a flange 530 to which the elements of the processing bench are attached. The processing bench 500 usually includes the frame 580. The frame 580 is typically for supporting the evaporation boat 550 where evaporation takes place. Typically, material to be evaporated is provided to the evaporation boat through the feeder 540. Typically, the material is provided in form of a wire. Further, a drive system 560 is disposed on the frame to drive the substrate to be coated. Typically, the insert element 500 further includes a protection shield 520 to prevent coating of the elements in the drive system 560. Further, the insert element 500 may include a cooling plate 510 for avoiding excessive heating of other components within the processing chamber. In addition, it is typical to arrange a shutter 570 in order to control the exposure of the substrate to the coating material being evaporated.

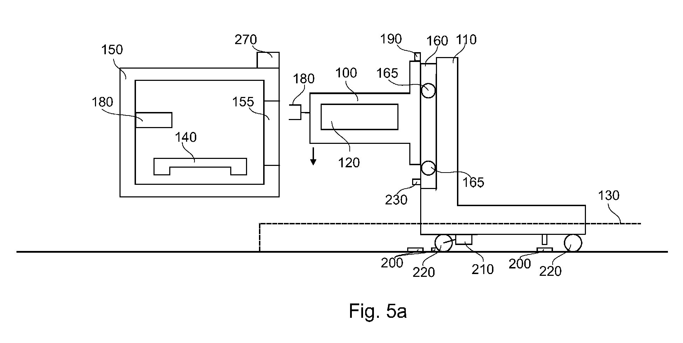

Figures 5a to 5e show a typical implementation of the insert apparatus according to the present disclosure in different operational configurations. The figures show that the inserting apparatus may include a sensor system, including at least one sensor, for sensing the position of the elements in the insert apparatus or conditions of the coating system. This set of sensor may, for example, include: a first hoist positioning sensor 190 which typically detects an upper position of the insert element 100; a second hoist positioning sensor 230 which typically detects a lower position of the insert element 100; a carrier positioning sensor 200 which typically detects relative positions of the carrier 110 with respect to the processing chamber 150; and a closing detection sensor 270 which typically detects when the processing chamber 150 is closed. Further, these sensors may be independently used or combined in different forms. Further, the sensor system may include additional sensors and/or detectors for detecting different configurations of the coating system. Those sensors may consist of any kind of position sensors based on optical, electric, electro-chemical, or electro-magnetic means. In particular, those sensors may consist of switches which mechanically detect the position of different elements of the inserting apparatus.

The insert apparatus shown in Figs. 5a to 5e further includes a gross positioning drive 210 which drives the sliding device 220. Thereby, the carrier 110, along with the insert element 100, is typically displaced in collaboration with the first positioner 130 in the horizontal direction for insertion or retraction of the insert element 100 with respect to the processing chamber 150. Typically, the positioning drive 210 and the sliding device 220 includes frequency converters and brakes to control the positioning of the carrier 110. The sliding device 220 typically consists of wheels. Further, the embodiments shown in Figs. 5a to 5e also include a magnetic coupler 180 for coupling a driving force to the insert element. Typically, this driving force is applied for conveying the substrate.

The embodiments of the inserting apparatus shown in Figs. 5a to 5e work as follows:

In the initial state, the carrier 110, along with the inserting element 100 and the processing bench 120, is in the servicing position as shown in Fig. 5a. At this stage the processing chamber 150 is open.

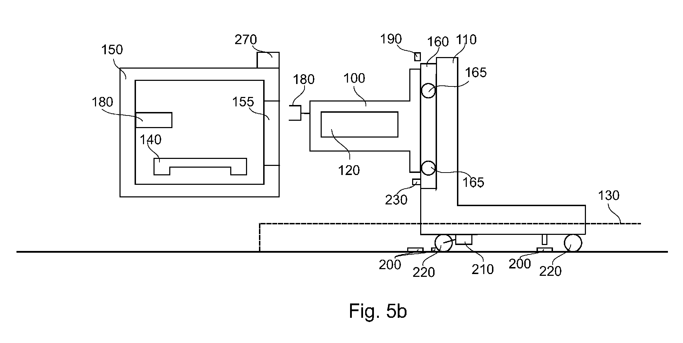

The carrier 110 remains in the servicing position while the insert element 100 is vertically displaced by the hoist device 165. Thereby, the insert element 100 is vertically displaced by the hoist device 165(see arrow in Fig. 5a) so that it may be inserted in the processing chamber 150 through an opening 155 as shown in Fig. 5b. Typically, the hoist device 165 consists of compressed air cylinders or the like. Typically, the insert element 100 is vertically displaced until the first hoist positioning sensor 190 detects the position at which the insert element 100 is vertically aligned with the upper rand of the opening 155. In this step, the insert element 100 is typically displaced in the vertical direction a distance between 10 mm and 50 mm, such as between 20 mm and 40 mm.

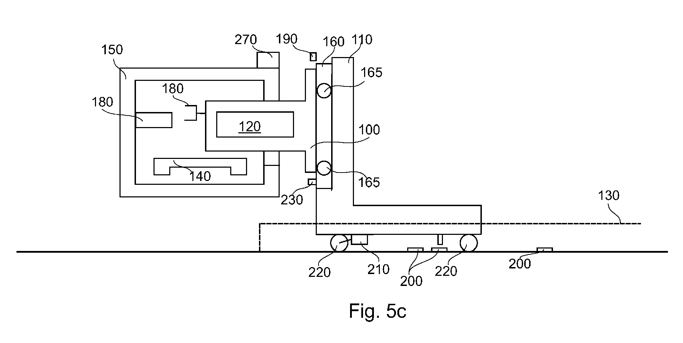

In a further step, the carrier 110 is grossly positioned within the chamber as shown in Fig. 5c. Thereby, the carrier 110 is horizontally displaced so that the insert element 100 is introduced into the processing chamber 150. Typically, the carrier positioning sensor 200 detects when the carrier 110 has been grossly positioned so that the horizontal distance between the flange 310 and the opening 155 is between 70 mm and 130 mm, such as between 85 mm and 115 mm.

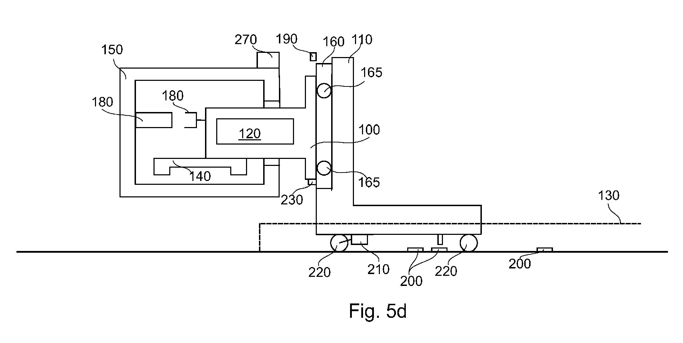

In a still further step, the insert element 100 is lowered by the hoist device 165, so that the insert element 100 is placed in contact with the second positioner 140, as shown in Fig. 5d. Typically, this position of the insert element 100 is detected by the second hoist positioning sensor 230. Typically, by this step, the insert element 100 is lowered between 10 mm and 50 mm, such as between 20 mm and 40 mm.

In a final step, the carrier 110 is displaced through the gross positioning drive 210 so that the insert element 100 slides in collaboration with the second positioner 140 until reaching the end position, i.e. closed position of the insert apparatus, as shown in Fig. 5e. Typically, when the end position is reached, a coupler 180, such as a magnetic coupler, is engaged to the insert element 100. Thereby, a driving force may be transmitted to a driving system in the inserting element. This driving system is typically for conveying the substrate during the coating process. When this position is reached, the processing chamber 150 is closed and, if required, sealed so that vacuum conditions inside the chamber may be generated. Typically, when the end position is reached, a substrate carrier 240 is introduced in the processing chamber 150 through a transport system. In principle, at this point, the coating system may be operated for coating of the substrate.

Preferably, the insert apparatus is automatically operated through a control system. In particular, insertion and extraction of the insert element may be performed automatically through a control system such as a computer programmed by appropriate software and communicating with the different components of the insert apparatus. However, the insert apparatus may be also operated manually.

In some embodiments, the insert apparatus further includes a clamping system for clamping of the insert element within the processing chamber. Thereby, fine positioning of the insert element within the processing chamber is complemented by the clamping system. Typically, clamping is performed by a clamping device which fixes the position of the insert element within the processing chamber. In particular, the clamping device may consist of a magnetic clamping device, a mechanical clamper or the like.

The clamping system may form part of the second positioner. In this particular case, the clamping system may perform the fine positioning of the insert element, either in collaboration with other devices, such as sliding elements or the like, which may collaborate with track elements within the processing chamber, or as a stand-alone device. In particular, the combination of the clamping system with elements of the second positioner may enhance the fine positioning capability of the insert apparatus.

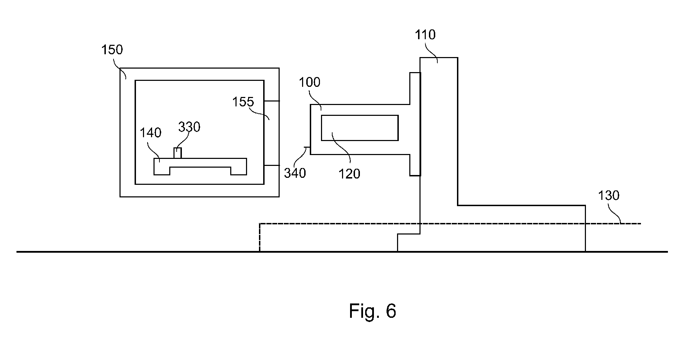

Fig. 6 shows embodiments of the insert apparatus wherein the second positioner 140 includes a clamping device 330. The clamping device 330 is for fixing the insert element 100 in an end position. Thereby, fine positioning of the insert element 100 within the chamber is facilitated. The insert element may include a fixing element 340 which can be coupled to the clamping device 330.

Typically, a coating system may have several processing chambers. For that case, the use of several insert elements according to the present disclosure within a single facility creates a modular system in which complete processing stations may be easily replaced by a fully equipped unit. It is thus possible to replace the coating tools more rapidly without diminishing the performance of the system due to the great exactitude with which insert elements may be placed within a processing chamber. This proves to be particularly favorable because the intervals during which target replacement has to be performed may vary for different insert elements designed for different tasks.

In a coating system including a plurality of processing chambers, a configuration of insert elements on one side of aligned processing chambers is, in principle, realizable. There is, in practice, sufficient working space when every second insert is pulled out, and thereby enabling work to be performed simultaneously on the retracted inserts. It is, however, possible to carry out work simultaneously on all the insert elements when every second insert is moved to a workstation further away from the system. In principle, a configuration of insert elements on both sides of a processing chamber is possible, too.

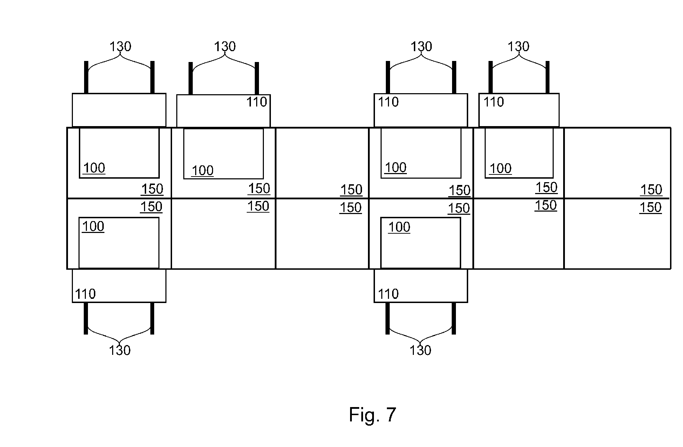

Fig. 7 shows a typical configuration of a coating system 500 including a plurality of processing chambers 150. Some of the processing chambers 150 include an insert apparatus according to the present disclosure. In particular, Fig. 7 shows a typical implementation of the embodiments according to the present disclosure where the first positioner consists of guides 130, such as rails or the like, which are placed on the floor of the facility and adjacent to the processing chambers 150. Fig. 7 shows that a plurality of insert apparatuses according to the present disclosure may be combined in a single coating facility.

In particular, the processing bench in the insert apparatus according to the present disclosure may be adapted for the fabrication of thin-film solar cells. In that case, the processing bench may be designed to perform metallization of thin-film solar cells. Thereby, the metallization of the thing-film solar cell may result in a film consisting of, for example, aluminum, silver, nickel, copper, or a layer sequence of different metals. In particular, the apparatuses and/or methods described herein may be used for producing the back contact of a solar cell such as a thin-film solar cell.

While the foregoing is directed to embodiments of the present disclosure, other and further embodiments may be devised without departing from the basic scope thereof, and the scope thereof is determined by the claims that follow.

This written description uses examples to disclose the present disclosure, including the best mode, and also to enable any person skilled in the art to make and use the present disclosure. While the embodiments have been described in terms of various specific embodiments, those skilled in the art will recognize that the present disclosure may be practiced with modification within the spirit and scope of the claims. Especially, mutually non-exclusive features of the embodiments described above may be combined with each other. The patentable scope of the embodiments is defined by the claims, and may include other examples that occur to those skilled in the art. Such other examples are intended to be within the scope of the claims if they have structural elements that do not differ from the literal language of the claims, or if they include equivalent structural elements with insubstantial differences from the literal languages of the claims.

## Claims

1. An insert apparatus for a substrate coating system comprising:
an insert element (100) for being operated within a coating system, the insert element comprising a processing bench (120), said processing bench (120) being adapted for receiving a coating tool for applying a coating to a substrate,
a carrier (110) for carrying the insert element (100),
a first positioner (130) collaborating with the carrier (110) for inserting said insert element (100) into a processing chamber (150) of the coating system and/or retracting said insert element (100) from said processing chamber (150), and
a second positioner (140) for fine positioning of said insert element (100) within said processing chamber (150).

2. The insert apparatus according to claim 1 further comprising an electrical unit block (250) for providing an operating voltage to said processing bench (120), said electrical unit block (250) being movable along with said carrier (110).

3. The insert apparatus according to claim 2 further comprising a multi-contact connection for establishing an electrical contact between said evaporator bench (120) and the electrical unit block (250).

4. The insert apparatus according to claim 3 wherein said multi-contact connection is adapted for establishing electrical contact when said insert element (100) is displaced, typically by vertical displacement of the insert element (100) to a position where electrical connection is established through said multi-contact connection between said electrical unit block (250) and components in the insert element (100).

5. The insert apparatus according to any of the preceding claims wherein at least one of the first and second positioner (130; 140) comprise guiding elements.

6. An insert apparatus for a substrate coating system comprising:
an insert element (100) for being operated within a coating system, the insert element comprising a processing bench (120), said processing bench (120) being adapted for receiving a coating tool for applying a coating to a substrate,
a carrier (110) for carrying the insert element (100), and
an electrical unit block (250) for providing an operating voltage to the processing bench (120), said electrical unit block (250) being movable along with the carrier (110).

7. The insert apparatus according to any of the preceding claims wherein said insert element (100) is movably coupled to said carrier (110).

8. The insert apparatus according to any of the preceding claims wherein said processing bench (120) comprises a coating tool for applying a coating to a substrate.

9. The insert apparatus according to any of the preceding claims wherein said insert element (100) is detachably coupled to said carrier (110).

10. The insert apparatus according to any of the preceding claims having at least one of cable carrier, drag chains, energy chains, cable chains or the like for generating a mechanical force for insertion or retraction of the insert element.

11. The insert apparatus according to any of the preceding claims further including at least one sensor for detecting the position of said insert element (100) and said carrier (110) during insertion of said insert element (100) into said processing chamber (150) and/or retraction of said insert element (100) from said processing chamber (150).

12. The insert apparatus according to any of the preceding claims wherein the processing bench (120) is adapted for producing a back contact in the production of a solar cell.

13. A method for inserting an insert element (100) in a substrate coating system, the method comprising:
disposing said insert element (100) on a carrier (110),
disposing an electrical unit block (250) in the substrate coating system so that said electrical unit block (250) is movable along with the carrier (110), and
positioning said insert element (100) into a processing chamber (150) of said coating system by displacing said carrier (110) whereby the electrical unit block (250) is also displaced.

14. A method for inserting an insert element (100) in a substrate coating system, the method comprising:
disposing said insert element (100) on a carrier (110),
grossly positioning said insert element (100) into a processing chamber (150) of said coating system; and
finely positioning of said insert element (100) within said processing chamber (150).

15. The method according to any of the claims 13 or 14 wherein the insertion is performed automatically through a control system.

## Amended claims

### Amended claims in accordance with Rule 137(2) EPC.

**1.** An insert apparatus for a substrate coating system comprising:
an insert element (100) for being operated within a coating system, the insert element comprising a processing bench (120), said processing bench (120) being adapted for receiving a coating tool for applying a coating to a substrate,
a carrier (110) for carrying the insert element (100),
a first positioner (130) collaborating with the carrier (110) for inserting said insert element (100) into a processing chamber (150) of the coating system and/or retracting said insert element (100) from said processing chamber (150), and
a second positioner (140) for fine positioning of said insert element (100) within said processing chamber (150).

**2.** The insert apparatus according to claim 1 further comprising an electrical unit block (250) for providing an operating voltage to said processing bench (120), said electrical unit block (250) being movable along with said carrier (110).

**3.** The insert apparatus according to claim 2 further comprising a multi-contact connection for establishing an electrical contact between said processing bench (120) and the electrical unit block (250).

**4.** The insert apparatus according to claim 3 wherein said multi-contact connection is adapted for establishing electrical contact when said insert element (100) is displaced, for example by vertical displacement of the insert element (100) to a position where electrical connection is established through said multi-contact connection between said electrical unit block (250) and components in the insert element (100).

**5.** The insert apparatus according to any of the preceding claims wherein at least one of the first and second positioner (130; 140) comprise guiding elements.

**6.** The insert apparatus according to any of the preceding claims wherein said insert element (100) is movably coupled to said carrier (110).

**7.** The insert apparatus according to any of the preceding claims wherein said processing bench (120) comprises a coating tool for applying a coating to a substrate.

**8.** The insert apparatus according to any of the preceding claims wherein the coating tool is for evaporation of a coating material.

**9.** The insert apparatus according to any of the preceding claims wherein said insert element (100) is detachably coupled to said carrier (110).

**10.** The insert apparatus according to any of the preceding claims having at least one of cable carrier, drag chains, energy chains, cable chains or the like for generating a mechanical force for insertion or retraction of the insert element.

**11.** The insert apparatus according to any of the preceding claims further including at least one sensor for detecting the position of said insert element (100) and said carrier (110) during insertion of said insert element (100) into said processing chamber (150) and/or retraction of said insert element (100) from said processing chamber (150).

**12.** The insert apparatus according to any of the preceding claims wherein the processing bench (120) is adapted for producing a back contact in the production of a solar cell.

**13.** A method for inserting an insert element (100) in a substrate coating system, the insert element comprising a processing bench (120), said processing bench (120) comprises a coating tool for applying a coating to a substrate the method comprising:
disposing said insert element (100) on a carrier (110),
grossly positioning said insert element (100) into a processing chamber (150) of said coating system; and
finely positioning of said insert element (100) within said processing chamber (150).

**14.** The method according to claim 13, further comprising
disposing an electrical unit block (250) in the substrate coating system so that said electrical unit block (250) is movable along with the carrier (110), and
positioning said insert element (100) into a processing chamber (150) of said coating system by displacing said carrier (110) whereby the electrical unit block (250) is also displaced.

**15.** The method according to any of the claims 13 or 14 wherein the insertion is performed automatically through a control system.
